# EUROPÄISCHE PATENTSCHRIFT

(11) **EP 3 726 436 B1**
(45) Veröffentlichungstag und Bekanntmachung des Hinweises auf die Patenterteilung: **05.06.2024**
(21) Anmeldenummer: 20168777.9
(22) Anmeldetag: 08.04.2020
(51) Int. Cl.: G06N 3/08, B60W 50/00, G06N 3/04

(54) **VERFAHREN ZUM ERMITTELN VON FAHRVERLÄUFEN**
METHOD FOR DETERMINING VEHICLE PATHS
PROCÉDÉ DE DÉTERMINATION DES COURSES

(30) Priorität: 16.04.2019 DE 102019205520
(43) Veröffentlichungstag der Anmeldung: 21.10.2020
(73) Patentinhaber: Robert Bosch GmbH, 70442 Stuttgart (DE)
(72) Erfinder: Schiegg, Martin, 70825 Korntal-Muenchingen (DE); Angermaier, Stefan, 70327 Stuttgart (DE); Zafar, Muhammad Bilal, 71272 Renningen (DE)

(56) Entgegenhaltungen:
- EP-A1- 2 610 836
- DE-A1-102013 200 116
- DE-A1-102017 107 271
- US-A1- 2005 166 580
- US-A1- 2018 364 725
- US-A1- 2019 012 581

## Beschreibung

Die Erfindung betrifft computerimplementierte Verfahren zum Generieren oder Bewerten von Fahrverläufen eines Fahrzeugs mittels eines maschinellen Lernsystems, ein computerimplementiertes Verfahren zum Anlernen eines solchen maschinellen Lernsystems sowie hierzu eingerichtete Computerprogramme und Lernsysteme.

### Stand der Technik

Die DE 10 2017 107 271 A1 offenbart ein Verfahren zur Ermittlung eines Leitfahrzyklus für Fahrversuche zur Ermittlung von Abgasemissionen von Kraftfahrzeugen. Dabei werden Geschwindigkeitsprofile für die verschiedenen Fahrzyklen auf Basis der Parametersätze abgeleitet. Ziel ist das Ermitteln eines Leitzyklus, der möglichst den "Maximal"-Emissionsfall innerhalb gegebener Randbedingungen widerspiegelt.

Die US 2018/0364 725 A offenbart ein Verfahren zur Vorhersage von Geschwindigkeit und Trajektorie eines Fahrzeugs auf Basis einer Fahrtroute, die vom Fahrzeug abgefahren werden soll.

### Offenbarung der Erfindung

In einigen Ländern sieht die Gesetzgebung vor, die Zulassung neuer Kraftfahrzeuge, die mittels einer Brennkraftmaschine angetrieben werden, abhängig von den Emissionen zu machen, die sich im praktischen Fahrbetrieb ergeben. Hierfür ist auch die englische Bezeichnung *real driving emissions* gebräuchlich. Solche Kraftfahrzeuge umfassen beispielsweise solche, die ausschließlich von einem Verbrennungsmotor angetrieben werden, aber auch solche mit einem hybridisierten Antriebsstrang.

Hierzu ist vorgesehen, dass ein Prüfer mit dem Kraftfahrzeug einen Fahrzyklus oder mehrere Fahrzyklen bestreitet und die dabei entstehenden Emissionen gemessen werden. Die Zulassung des Kraftfahrzeugs ist dann abhängig von diesen gemessenen Emissionen. Der Fahrzyklus kann hierbei innerhalb weiter Grenzen vom Prüfer frei gewählt werden. Eine typische Dauer eines Fahrzyklus kann hierbei beispielsweise 90-120min betragen.

Für Hersteller von Kraftfahrzeugen stellt sich damit in der Entwicklung von Kraftfahrzeugen die Herausforderung, bereits frühzeitig im Entwicklungsprozess eines neuen Kraftfahrzeugs absehen zu müssen, ob die Emissionen dieses Kraftfahrzeugs in jedem zulässigen Fahrzyklus innerhalb der gesetzlich vorgeschriebenen Grenzen bleibt, oder nicht.

Es ist daher wesentlich, Verfahren und Vorrichtungen bereitzustellen, die bereits im Entwicklungsstadium eines Kraftfahrzeugs die voraussichtlichen Emissionen des Kraftfahrzeugs sicher vorhersagen kann, um im Falle eines voraussichtlichen Überschreitens von Grenzwerten Änderungen am Kraftfahrzeug durchführen zu können. Eine derartige Abschätzung allein auf Basis von Messungen auf einem Prüfstand bzw. in einem fahrenden Kraftfahrzeug ist wegen der großen Vielfalt denkbarer Fahrzyklen überaus aufwändig.

Im Stand der Technik wird daher zum Beispiel vorgeschlagen, sogenannte Leitzyklen zu bestimmen, für die eine Erfüllung von Emissionsvorgaben besonders herausfordernd ist. Dabei wird davon ausgegangen, dass mutmaßlich für alle denkbaren Fahrzyklen die Emissionsvorgaben erfüllt sein werden, wenn dies für die herausforderndsten Zyklen der Fall ist.

Neben der Anforderung, in jedem denkbaren bzw. zulässigen Fahrzyklus Abgasvorschriften erfüllen zu müssen, ist es allerdings ein bedeutendes Ziel einer Fahrzeug- bzw. Antriebsentwicklung, die Gesamtemissionen eines Fahrzeug-Antrieb-Systems im Realbetrieb zu minimieren. Bei einer Anpassung bzw. Optimierung eines Fahrzeug-Antrieb-Systems auf die kritischsten bzw. besonders kritische Fahrzyklen kann zwar möglicherweise eine Erfüllung von Normen in allen Zyklen gewährleistet werden, es besteht dadurch aber die Gefahr einer deutlichen Verschlechterung der Emissionen in weniger kritischen Zyklen. Sind dann noch die weniger kritischen Zyklen im realen Fahrbetrieb die häufigeren Zyklen, was häufig der Fall ist, verschlechtert sich durch eine solche Optimierung das Gesamtsystem bezüglich Emissionen im Realbetrieb. Beispielsweise kann eine Optimierung der Emissionen auf einen kritischen, aber in der Realität sehr seltenen Fahrzyklus mit einem extremen Geschwindigkeitsprofil (z.B. extreme Bergfahrt mit starken Beschleunigungen) dazu führen, dass diese sich für weniger kritische, aber dafür viel häufigere Fahrzyklen mit gewöhnlichem Geschwindigkeitsprofil (z.B. kurze Stadtfahrt mit Ampeln) verschlechtern, was insgesamt zu höheren Emissionen in Realbetrieb führen kann.

Es ist daher für die Entwicklung emissionsoptimierter Fahrzeuge mit Verbrennungsmotoren von großem Vorteil, eine große Anzahl realistischer Geschwindigkeitsprofile automatisch generieren zu können, deren Verteilung der generierten Geschwindigkeitsprofile einer real zu erwartenden Verteilung entspricht oder diese approximiert. Ziel sind somit generierte Geschwindigkeitsprofile mit einer für den Realbetrieb repräsentativen Verteilung.

Neben der Entwicklung von emissionsarmen Antriebssystemen bzw. einer emissionsoptimierten Applikation solcher Antriebssysteme können solche generierten Geschwindigkeitsprofile vorteilhafterweise auch bei einem prädiktiven Fahren verwendet werden, z.B. im Batteriemanagement eines Elektrofahrzeugs oder E-Bikes, dem Antriebsmanagement eines Hybridfahrzeugs, dem Regenerationsmanagement von Abgaskomponenten eines Fahrzeugs mit Verbrennungsmotors. Auch für die Ermittlung von Lastkollektiven und Belastungsszenarien zur Spezifikation von Bauteilen können derart generierte Geschwindigkeitsprofile einen wertvollen Beitrag leisten, z.B. welche Belastung erfährt ein bestimmtes Bauteil, wie bspw. eine Pumpe über seine Lebenszeit.

Somit stellt die computergestützte Generierung von Geschwindigkeitsprofilen in für den Realbetrieb repräsentativer Verteilung eine wichtige technische Aufgabe dar, welche in verschiedenen Szenarien die Entwicklung oder Optimierung eines Fahrzeugs entscheidend verbessern kann und damit zu emissionsärmeren und effizienteren Fahrzeugen, insbesondere zu emissionsärmeren und effizienteren Antriebssystemen von Fahrzeugen beitragen.

Vorgestellt wird somit in einem ersten Aspekt ein computerimplementiertes Verfahren zum Trainieren eines maschinellen Lernsystems zum Generieren von Fahrverläufen eines Fahrzeugs.

Fahrverläufe bezeichnen dabei Verläufe von Fahreigenschaften eines Fahrzeugs, wobei die Fahreigenschaften mit Sensoren messbare, insbesondere physikalische oder technische Eigenschaften des Antriebsstrangs des Fahrzeugs sind, welche die Fortbewegung eines Fahrzeugs charakterisieren. Als bedeutendste Variante fallen unter die Fahrverläufe Geschwindigkeitsverläufe des Fahrzeugs. Der Geschwindigkeitsverlauf eines Fahrzeugs ist für eine bestimmte Fahrt eine oder die Leitgröße zur Bestimmung von Emissionen, Verbrauch, Verschleiß und vergleichbaren Größen. Ein Geschwindigkeitsverlauf kann dabei durch Geschwindigkeitswerte, aber auch durch daraus ableitbare Größen wie Beschleunigungswerte bestimmt sein. Andere wesentliche Fahreigenschaften, deren Verläufe für Anwendungen wie der Bestimmung von Emissionen, Verbrauch oder Verschleiß wesentlich sind, umfassen insbesondere eine Stellung des Fahrpedals oder eine Getriebeübersetzung.

Das Trainingsverfahren hat dabei die Schritte:
- ein Generator des maschinellen Lernsystems erhält erste Zufallsvektoren als Eingangsgrößen und generiert zu den ersten Zufallsvektoren jeweils erste Fahrtrouten und zugehörige erste Fahrverläufe,
- in einer Datenbank sind Fahrtrouten und jeweils zugehörige, im Fahrbetrieb erfasste Fahrverläufe abgespeichert,- aus der Datenbank werden zweite Fahrtrouten sowie jeweils zugehörige zweite, im Fahrbetrieb erfasste Fahrverläufe ausgewählt,
- ein Diskriminator des maschinellen Lernsystems erhält als Eingangsgrößen erste Paare aus ersten generierten Fahrtrouten und jeweils zugehörigen ersten, generierten Fahrverläufen und zweite Paare aus zweiten Fahrtrouten und jeweils zugehörigen zweiten, im Fahrbetrieb erfassten Fahrverläufen,
- der Diskriminator berechnet abhängig von den Eingangsgrößen Ausgaben, welche für jedes als Eingangsgrößen erhaltene Paar charakterisieren, ob es sich um ein erstes Paar aus einer ersten generierten Fahrtroute und einem jeweils zugehörigen ersten,
generierten Fahrverlauf oder um ein zweites Paar aus einer zweiten Fahrtroute und einem jeweils zugehörigen zweiten, im Fahrbetrieb erfassten Fahrverlauf handelt, - abhängig von den Ausgaben des Diskriminators wird eine Zielfunktion optimiert, welche eine Distanz zwischen der Verteilung der ersten Paare und der Verteilung der zweiten Paare darstellt.

Vorzugsweise werden abhängig von der Optimierung der Zielfunktion Parameter des maschinellen Lernsystems derart angepasst, dass
a. der Diskriminator darauf optimiert wird, zwischen den ersten, generierten Fahrverläufen und den zweiten, im Fahrbetrieb erfassten Fahrverläufen zu unterscheiden,
b. der Generator darauf optimiert wird, erste, generierte Fahrverläufe in einer ersten Verteilung zu generieren, welche durch den Diskriminator möglichst schwer von zweiten, im Fahrbetrieb erfassten Fahrverläufen zu unterscheiden sind, welche in einer zweiten Verteilung vorliegen.

In einer bevorzugten Ausgestaltung werden die Parameter des maschinellen Lernsystems abhängig von einem Gradienten der Zielfunktion angepasst.

Die vorgestellten Trainingsverfahren stellen ein computerimplementiertes maschinelles Lernsystem zur Verfügung, mit welchem repräsentative Fahrverläufe und repräsentative Fahrtrouten bzw. repräsentative Paare aus Fahrverläufen und Fahrrouten generiert werden können, wodurch wiederum Maßnahmen wie eine Emissionsoptimierung bzw. eine Validierung eines Systems bezüglich Emissionen unter Berücksichtigung der tatsächlichen, repräsentativen Auswirkungen erfolgen können. Beispielsweise können als repräsentative Fahrrouten Routen mit der Routeneigenschaft Steigung generiert werden und als repräsentative Fahrverläufe Geschwindigkeitsverläufe. In Kombination können mit diesen generierten Größen diverse Optimierungen von Antriebssystemen bzw. deren Validierung automatisiert durchgeführt werden.

Die Zielfunktion ist vorzugsweise als eine statische Distanz wie z.B. eine Jenson-Shannon-Distanz implementiert. Bevorzugt wird die Zielfunktion als Wasserstein-Metrik implementiert, insbesondere eine Wasserstein-Distanz zwischen einer ersten Verteilung der ersten Fahrverläufe und einer zweiten Verteilung der zweiten Fahrverläufe. Vorteilhafterweise spiegelt somit die Verteilung der generierten Daten die volle Varianz der Verteilung der gemessenen Daten wider, ein sogenannter Mode Collapse wird verhindert. Zudem werden ein stabileres und effizienteres Training und bessere Konvergenz ermöglicht, da diese Zielfunktion verschwindende Gradienten (vanishing gradients) verhindert. Die Zielfunktion ist robust gegenüber zu vielen Optimierungsschritten beim Diskriminator. Um den Einsatz einer Wassersteinmetrik als Zielfunktion zu optimieren, wird in bevorzugten Ausgestaltungen vorgeschlagen, die Zielfunktion um einen Reglementierer zu erweitern oder ein weight clipping durchzuführen.

Ergänzend können die Eingangsgrößen des Generators und des Diskriminators jeweils zusätzliche Informationen umfassen, insbesondere Fahrereigenschaften und / oder Fahrzeugeigenschaften. Durch solche, insbesondere auch nicht diskretisierte, Zusatzinformationen können die Fahrverläufe auch auf weitere Grö-ßen konditioniert werden, beispielsweise eine Motorisierung des Fahrzeugs oder eine Erfahrung des Fahrers, was genauere Anpassungen und Schlussfolgerungen abhängig von den generierten Fahrverläufen ermöglicht.

Die Zufallsvektoren werden insbesondere von einem Zufallsgenerator erzeugt. Die Zufallsgrößen können vorzugsweise zum einen entweder als globale Zufallsvektoren oder als temporäre oder lokale Zufallsvektoren implementiert werden. Alternativ können die Zufallsgrößen auch als eine Kombination von globalen und von temporären oder lokalen Zufallsvektoren implementiert werden. Die Kombination von globalem und temporärem / lokalem Zufallsvektor stellt sich als besonders vorteilhaft heraus, da somit Varianzen in den Daten sowohl auf Grund von globalen, wie auch von lokalen bzw. temporären Einflüssen abgebildet werden können.

In bevorzugten Ausgestaltungen sind der Generator und / oder der Diskriminator jeweils als neuronales Netz, insbesondere als rekurrentes neuronales Netz implementiert. Hierdurch können auch Fahrverläufe beliebiger Länge generiert oder bewertet werden, wobei die Übergänge zwischen Abschnitten der Fahrverläufe stets konsistent mit dem gelernten Übergangsmodell sind. Das rekurrente neuronales Netz kann dabei insbesondere als long short-term memory (LSTM) neural network oder gated recurrent units (GRU) implementiert werden.

In bevorzugten Ausgestaltungen wird es vorteilhafterweise auch möglich, sogenanntes vorausschauendes Fahren zu berücksichtigen. Dabei wird berücksichtigt, dass sich die Geschwindigkeit eines Fahrzeugs durch Fahrerverhalten oder auch durch automatische Fahrzeugeingriffe bereits auf zukünftige bzw. nachfolgende Routeneigenschaften anpassen kann, beispielsweise durch eine bereits sichtbare Ampel, eine bekannte folgende Geschwindigkeitsbegrenzung etc. Hierzu kann der Generator in einer bevorzugten Ausgestaltung als bidirektionales rekurrentes neuronales Netz implementiert werden.

In weiteren vorgestellten Aspekten können die mit den vorgestellten Trainingsverfahren angelernten Elemente des maschinellen Lernsystems als computerimplementierte Systeme eingesetzt werden, um Fahrverläufe zu generieren (Generator) oder zu bewerten (Diskriminator).

Insbesondere kann abhängig von derart generierten Fahrverläufen eine Ermittlung von routenspezifischen Emissionen eines Antriebssystems eines Fahrzeugs erfolgen, beispielsweise in einer Simulation, in welcher ein Modell des Antriebssystems berechnet wird. Ein solches Modell kann dabei Teilmodelle umfassen, welche einen Motor und ein Abgasnachbehandlungssystem des Antriebssystems beschreiben.

Mit abhängig von derart generierten Fahrverläufen ermittelten routenspezifischen Emissionen eines Antriebssystems eines Fahrzeugs kann dann wiederum eine Validierung oder Anpassung des Antriebssystems erfolgen, insbesondere eine emissionsminimierende Anpassung.

Wie bereits beschrieben kann hierbei durch die repräsentative Verteilung der generierten Fahrverläufe eine Anpassung erfolgen, welche das Antriebssystem bezüglich Emissionen nicht auf einzelne oder besonders kritische Fahrverläufe optimiert. Vielmehr wird eine Optimierung des Antriebssystems derart ermöglicht, dass die im Realbetrieb zu erwartenden Emissionen insgesamt minimiert werden.

Die Optimierung kann dabei durch eine Anpassung von Komponenten oder Parametern in der Entwicklung des Antriebssystems, durch eine Anpassung von Daten in einer Applikation des Antriebssystems oder durch eine Anpassung von Steuergrößen im Betrieb des Antriebssystems im Fahrzeug erfolgen.

Zur Durchführung der beschriebenen, computerimplementierten Verfahren können Computerprogramme eingerichtet sein und auf maschinenlesbaren Speichern abgelegt werden. Ein computerimplementiertes Lernsystem umfassend einen solchen maschinenlesbaren Speicher kann dazu eingerichtet sein, die Verfahren durchzuführen, wobei die durchzuführenden Berechnungen durch einen oder mehrere Prozessoren des computerimplementierten Lernsystems ausgeführt werden.

### Beschreibung der Ausführungsbeispiele

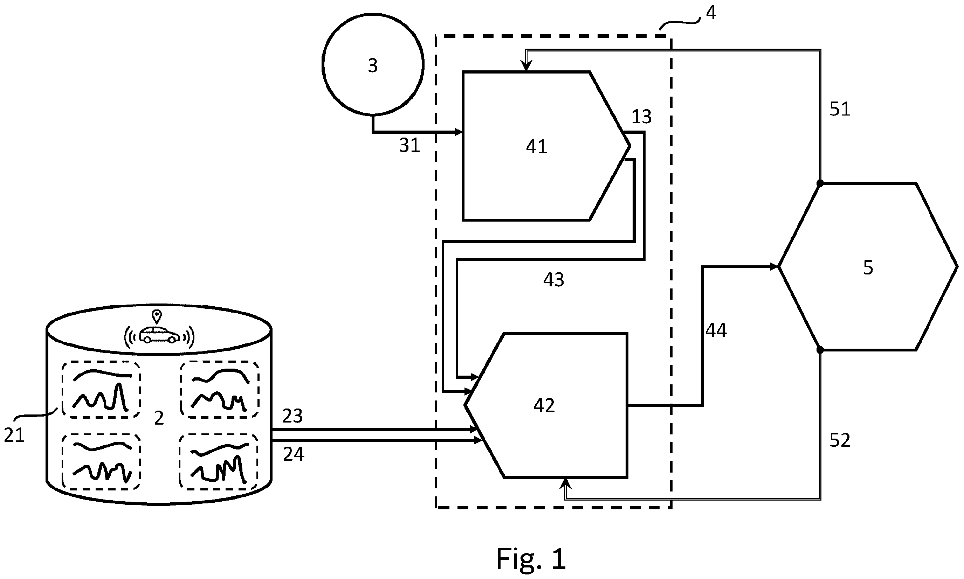

Figur 1 zeigt beispielhaft ein computerimplementiertes Trainingsverfahren für ein maschinelles Lernsystem.

In einer Datenbank 2 sind Fahrtrouten bzw. Routen von Fahrzeugen gemeinsam mit jeweils einem zugehörigen Fahrverlauf abgelegt. Eine beispielhaftes Paar aus Route und zugehörigem Fahrverlauf in der Datenbank 2 ist in Fig. 1 mit 21 bezeichnet. Die Fahrverläufe in Datenbank 2 entsprechen dabei im Fahrbetrieb des Fahrzeugs ermittelten oder gemessenen Fahrverläufen. D.h. die Fahrverläufe wurden vorzugsweise beim tatsächlichen Abfahren der zugehörigen Route mit einem Fahrzeug von Sensoren des Fahrzeugs erfasst und abgespeichert. Dabei werden mit Datenbank lediglich auf einem maschinenlesbaren Speicher systematisch abgelegte Daten bezeichnet.

Im maschinellen Lernsystem 4 soll nun ein Generator 41 darauf trainiert werden, Fahrverläufe sowie zugehörige Fahrrouten zu generieren. Diese Fahrverläufe sollen abhängig von zufälligen Eingangsgrößen bestimmt werden, wozu in Block 3 Zufallsgrößen wie Zufallsvektoren bereitgestellt werden können. In Block 3 kann insbesondere ein Zufallsgenerator implementiert sein, wobei es sich dabei auch um einen Pseudozufallsgenerator handeln kann.

Die durch den Generator 41 generierten Fahrverläufe sollen vorzugsweise von den im Fahrbetrieb ermittelten Fahrverläufen aus der Datenbank 2 möglichst nicht oder kaum unterscheidbar sein. Hierzu wird ein Diskriminator 42 darauf trainiert, möglichst gut zwischen durch Generator 41 generierten Fahrverläufen und von Datenbank 2 gezogenen Fahrverläufen, bzw. zwischen den jeweiligen Paaren aus Fahrverläufen und Fahrrouten bzw. Routeneigenschaften unterscheiden zu können. Das Lernsystem soll dabei nicht nur einzelne Fahrverläufe und Fahrrouten generieren, die möglichst nicht oder kaum von einzelnen im Fahrbetrieb ermittelten Fahrverläufen unterschieden werden können. Vielmehr soll auch die Verteilung der generierten Fahrverläufe und Fahrrouten im Parameterraum der Eingangsgrößen möglichst nahe an der Verteilung der im Fahrbetrieb ermittelten Fahrverläufe und Fahrrouten im Parameterraum der Eingangsgrößen liegen, also eine repräsentative Verteilung von Fahrverläufen und Fahrtrouten erreicht werden.

Das Training des maschinellen Lernsystems 4 umfasst hierzu die Optimierung einer Zielfunktion 5, abhängig von welcher Parameter des Generators 41 und des Diskriminators 42 angepasst werden.

Im Folgenden soll das vorgeschlagene Training des maschinellen Lernsystems 4 anhand von Fig. 1 detaillierter beschrieben werden.

Eine Route ist insbesondere als Abfolge diskreter Datenpunkte bestimmt, wobei für jeden Datenpunkt bzw. jeden Diskretisierungsschritt Routeneigenschaften in diesem Diskretisierungsschritt gespeichert sind. Das gilt insbesondere für generierte Routen wie für in der Datenbank gespeicherte Routen.

Eine Route r weist beispielsweise eine Länge N auf: r = (*r*₁, ... , *r_{N}*). Jeder Datenpunkt *rₜ* entspricht einem Diskretisierungsschritt. Besonders bevorzugt sind Realisierungen, in denen die Diskretisierungsschritte einer zeitlichen oder räumlichen Diskretisierung entsprechen. Bei der zeitlichen Diskretisierung entsprechen die Datenpunkte jeweils einer verstrichenen Zeit seit Beginn der Route und damit die Abfolge der Datenpunkt einem zeitlichen Verlauf. Bei der räumlichen Diskretisierung entsprechen die Datenpunkte jeweils einer zurückgelegten Strecke entlang der Route.

Die Abtastrate ist in der Regel konstant. In einer zeitlichen Diskretisierung kann die Abtastrate z.B. als x Sekunden definiert werden, in einer räumlichen Diskretisierung z.B. als x Meter.

Jeder Datenpunkt *rₜ* der Route beschreibt die Routeneigenschaften an dem entsprechenden Diskretisierungsschritt, d.h. *rₜ* ∈ *R^{D}.* D ist die Anzahl der Routeneigenschaften, wobei hierbei jede Dimension von mehrdimensionale Routeneigenschaften als eine Dimension einer eindimensionalen Routeneigenschaft gezählt wird.

Solche Routeneigenschaften können z.B. sein, jeweils bezogen auf den Diskretisierungsschritt, insbesondere den Zeitpunkt bzw. Zeitabstand oder den Ort bzw. die Strecke oder Entfernung:
- Geografische Eigenschaften wie absolute Höhe oder Steigung
- Eigenschaften des Verkehrsflusses wie zeitabhängige Durchschnittsgeschwindigkeit des Verkehrs
- Fahrbahneigenschaften wie Anzahl der Fahrspuren, Fahrbahntyp oder Fahrbahnkrümmung
- Eigenschaften der Verkehrsführung wie Geschwindigkeitsbeschränkungen, Anzahl der Ampeln oder Anzahl bestimmter Verkehrsschilder, insbesondere Stopp oder Vorfahrt gewähren oder Fußgängerüberwege
- Wettereigenschaften wie Regenmenge zum vorgegebenen Zeitpunkt, Windgeschwindigkeit, Existenz von Nebel

Dabei sind insbesondere die generierten Routen und die in der Datenbank abgespeicherten Routen durch die gleichen Routeneigenschaften bzw. Arten von Routeneigenschaften bestimmt.

In Block 3 wird ein Zufallsvektor ermittelt und dieser in Schritt 31 an den Generator 41 übermittelt. Ein Zufallsvektor z wird gezogen, das heißt zufällig ermittelt. Dabei gilt insbesondere *z*∈*R^{L}*, wobei L optional von der Länge der Route N abhängen kann. Die Verteilung, aus der z gezogen wird, ist vorzugsweise festgesetzt auf eine einfache Verteilungsfamilie, z.B. Gauß-Verteilung oder Gleichverteilung.

Die Eingangsgrößen des Generators 41 umfassen somit mindestens den Zufallsvektor z. Generator 41 generiert nun abhängig von den Eingangsgrößen (Schritt 31) Fahrverläufe und Fahrtrouten. Der Generator 42 verfügt hierzu über einen computerimplementierten Algorithmus, mit welchem ein generatives Modell umgesetzt ist und Fahrverläufe und Fahrtrouten ausgibt (Schritt 43).

Ein solcher durch den Generator 41 generierter Fahrverlauf kann beispielsweise als *x* =( *x*₁, ..., *x_{N}* ) ausgegeben werden und gleich wie die generierte zugehörige Fahrtroute über den Ort diskretisiert vorliegen. Alternativ können beispielsweise auch die generierten Routeneigenschaften, also die Fahrroute, diskretisiert über den Ort vorliegen, aber der generierte Fahrverlauf, also beispielsweise die generierten Geschwindigkeiten, diskretisiert über die Zeit.

Zur Beeinflussung bzw. Festlegung der Länge der generierten Fahrverläufe und Fahrtrouten kann in einer bevorzugten Ausgestaltung dem Generator 41 zusätzlich die Länge N der zu generierenden Fahrverläufe und Fahrrouten vorgegeben werden. Dies kann entweder ein festgelegter oder konfigurierbarer Wert sein oder in bevorzugter Variante aus einer Verteilung gesampelt werden, die repräsentativ für die wahre Verteilung der Routenlängen ist. Diese Verteilung kann zum Beispiel aus der beschriebenen oder einer anderen Datenbank extrahiert werden. Wird als Generator 41 ein rekurrentes Neuronales Netz eingesetzt, kann die Generierung dann nach N Schritten abgebrochen werden oder N als weitere Eingangsgröße des Generators 41 vorgesehen werden.

In einer alternativen Ausgestaltung wird ein bestimmtes Abbruchkriterium, insbesondere ein zufallbehaftetes Abbruchkriterium definiert, welches bei der Generierung die Länge der generierten Daten (Fahrverlauf, Fahrroute) bestimmt. Beispielsweise kann ein spezielles Symbol (z.B. $, -1, NAN) eingeführt werden, welches das Routenende signalisiert. Sobald der Generator 41 dieses Zeichen zum ersten Mal generiert, ist die Route beendet.

Das generative Modell ist parametrisiert über die Parameter *θ_{G}*. Die Architektur des Generativen Modells kann beispielsweise ein rekurrentes Neuronales Netz sein. Die Computerimplementierung des Generators erfolgt durch Ablage des Algorithmus, welcher das generative Modell umsetzt, sowie der Parameter des Modells in einem maschinenlesbaren Speicher, durch ein Abarbeiten der Berechnungsschritte des Algorithmus durch einen Prozessor sowie ein Speichern der generierten Fahrverläufe in einem maschinenlesbaren Speicher.

In einer möglichen Ausgestaltung können die Fahrverläufe mit einer fixen Länge generiert werden, d.h. mit einer festgelegten Zahl an Diskretisierungsschritten bzw. Datenpunkten. Bei Generierung längerer Fahrverläufe müssten dann mehrere generierte, kurze Zeitreihen aneinander gehängt werden. Die Übergänge wären dabei jedoch in der Regel nicht konsistent. In einer alternativen Ausgestaltung kann das Verfahren derart erweitert werden, dass auch Fahrverläufe beliebiger Länge generiert oder bewertet werden können und die Übergänge stets konsistent mit dem gelernten Übergangsmodell sind. Hierzu werden vorzugsweise sowohl der Generator, als auch der Diskriminator als rekurrentes neuronales Netz implementiert, beispielsweise als long short-term memory (LSTM) neural network oder gated recurrent units (GRU). Architektonisch ist der Generator vorzugsweise als Vektor-zu-Sequenz-Modell ausgeführt, kann aber auch als ein Sequenz-zu-Sequenz-Modell implementiert werden. Der Diskriminator ist vorzugsweise als Sequenz-zu-Skalar-Modell ausgeführt, kann aber auch als ein Sequenz-zu-Sequenz Modell implementiert werden.

Für die Architektur des generativen Modells als rekurrentes neuronales Netz ergeben sich verschiedene Optionen.

Beispielsweise kann ein globaler Zufallsvektors z für den kompletten Fahrverlauf gesampelt werden, wobei sich die Bezeichnung global wiederum auf eine zeitliche oder räumliche Diskretisierung beziehen kann. In dieser Ausgestaltung werden im latenten Raum Eigenschaften berücksichtigt bzw. gelernt, welche den Fahrverlauf global verändern, beispielsweise über die Route konstante Eigenschaften wie konstante Fahrereigenschaften (z.B. Alter oder Erfahrung), konstante Wettereigenschaften (z.B. Dauerregen) oder konstante Fahrzeugeigenschaften (z.B. Motorisierung). Dieser Zufallsvektor kann nun entweder zur Initialisierung des versteckten Zustands (hidden states) im ersten Zeitschritt verwendet werden oder/und dem rekurrenten neuronalen Netz in jedem Zeitschritt zugeführt werden.

Es können auch lokale bzw. temporäre Zufallsvektoren z gesampelt werden, d.h. im latenten Raum werden Eigenschaften berücksichtigt bzw. gelernt, welche den Fahrverlauf lokal bzw. temporär verändern, beispielsweise kurzfristige Eigenschaften wie kurzfristige Verkehrsführungs- oder Verkehrsflusseigenschaften (Zustände von Ampeln, Rückstau Kreuzung, Fußgänger auf der Fahrbahn). Ein Zufallsvektor wird dabei im Abstand von M Zeitschritten neu generiert und dem rekurrenten neuronalen Netz zugeführt, wobei M>0. M kann auch stochastisch sein, d.h. der Zufallsvektor kann auch in zufälligen Abständen geändert werden.

In einer bevorzugten Ausgestaltung kann auch eine Kombination von globalem und lokalen bzw. temporären Zufallsvektoren implementiert werden. Einige Dimensionen des Zufallsvektors werden dabei nur einmal pro Fahrverlauf gesampelt, die restlichen Dimensionen ändern sich alle M Zeitschritte. Alternativ kann hierzu auch ein globaler Zufallsvektor dem rekurrenten neuronalen Netz grundsätzlich in jedem Zeitschritt zugeführt werden, wobei er alle M Zeitschritte durch einen lokalen (d.h. neu gesampelten) Zufallsvektor ersetzt wird.

Die Kombination von globalem und lokalem Zufallsvektor stellt sich als besonders vorteilhaft heraus, da somit Varianzen in den Daten sowohl auf Grund von globalen, wie auch von lokalen bzw. temporären Einflüssen abgebildet werden können.

Vorzugsweise kann in dem generativen Modell auch vorausschauendes bzw. prädiktives Fahren berücksichtigt werden.

So kann ein bidirektionales rekurrentes Neuronales Netz als generatives Modell eingesetzt werden, in welchem ein versteckter Zustand (hidden state) zukünftiger Zellen des rekurrenten Neuronalen Netzes zusätzlich berücksichtigt wird. Hierdurch können explizit alle möglichen zukünftigen Zeitschritte mit einbezogen werden.

Statt also die Generierung einer Geschwindigkeit oder Routeneigenschaft zum Zeitpunkt t lediglich auf den inneren Zustand zum aktuellen Zeitpunkt t (sowie gegebenenfalls auf einen hidden state von Zeitpunkt t-1) zu konditionieren, können auch zukünftige innere Zustände, und damit indirekt auch zukünftige Routeneigenschaften und Geschwindigkeitsverläufe für die Generierung der Geschwindigkeit zum Zeitpunkt t mit einbezogen werden. Hiermit wird ermöglicht, sogenanntes "vorausschauendes Fahren" zu simulieren, beispielsweise die vorzeitige Reaktion eines Fahrers, vor allem im Sinne einer Geschwindigkeitsanpassung, auf eine in der Distanz bereits sichtbare Routeneigenschaft (z.B. Ampel, Geschwindigkeitslimitierung, Autobahnausfahrt etc.). Zudem wird ermöglicht, dass der Algorithmus lernen kann, am Ende einer Route zu Geschwindigkeit 0 zurückzukehren, beispielsweise indem am Ende einer Route nur noch Default-Werte wie z.B. 0 für zukünftige Routeneigenschaften vorliegen.

In der Datenbank 2 sind die derart bestimmten Routen jeweils gemeinsam mit einem der Route zugehörigen, im Fahrbetrieb tatsächlich gemessenen Fahrverlauf abgelegt. Diese Paare aus Route und zugehörigem Fahrverlauf dienen dem maschinellen Lernsystem als Trainingsdaten. Zu diesem Training werden insbesondere Paare aus Route und zugehörigem Fahrverlauf ausgewählt und in den Schritten 23 und 24 dem Diskriminator 42 übermittelt. Zudem werden dem Diskriminator 42 in den Schritten 13 bzw. 43 auch Paare bestehend aus einer generierten Fahrtroute und einem abhängig von dieser Route durch Generator 41 generierten Fahrverlauf übermittelt.

Der Diskriminator 42 verfügt über einen computerimplementierten Algorithmus, mit welchem ein diskriminatives Modell umgesetzt wird. Als Eingangsgrößen erhält der Diskriminator 42 ein Paar bestehend aus Route und zugehörigem Fahrverlauf und entscheidet, ob das gesehene Paar einen (durch Generator 41) generierten oder einen (aus Datenbank 2 erhaltenes) tatsächlich gemessenen Fahrverlauf beinhaltet. Das Ergebnis dieser Entscheidung wird in Schritt 44 ausgegeben. Z.B. kann der Diskriminator 42 einen Wert >0 für die Entscheidung "echter Fahrverlauf" und <0 für die Entscheidung "generierter Fahrverlauf' ausgeben. Alternativ können beispielsweise auch vorher festgelegte Werte wie Klassenlabels ausgegeben werden. Das diskriminative Modell ist parametrisiert über die Parameter *θ_{D}*. Die Ausgabe 44 der Entscheidung beinhaltet insbesondere eine Wertung über die binäre Entscheidung ,ja" / "nein" hinaus.

Die Computerimplementierung des Diskriminators erfolgt durch Ablage des Algorithmus, welcher das diskriminative Modell umsetzt, sowie der Parameter des Modells in einem maschinenlesbaren Speicher, durch ein Abarbeiten der Berechnungsschritte des Algorithmus durch einen Prozessor sowie ein Speichern der Ausgabe in einem maschinenlesbaren Speicher.

Der Diskriminator 42 kann beispielsweise als rekurrentes Neuronales Netz implementiert sein. Damit können insbesondere Fahrverläufe beliebiger Länge bewertet werden.

Für die Bewertung (Entscheidung generierte Fahrverläufe und Fahrrouten versus im Fahrbetrieb ermittelte Fahrverläufe und Routeneigenschaften) gibt es mehrere Ausgestaltungen. Die Bewertung kann insbesondere nach jedem einzelnen Zeitschritt neu abgegeben werden. Die globale Bewertung des Fahrverlaufs und der Fahrrouten ist dann z.B. der Durchschnitt der Einzelbewertungen oder die Mehrheitsentscheidung. Alternativ kann die Bewertung des gesamten Fahrverlaufs sowie der gesamten Fahrrouten auch nur zum letzten Zeitschritt abgegeben werden. Letztere Ausgestaltung spart insbesondere zusätzliche Berechnungsschritte und hat den weiteren Vorteil, dass der komplette Fahrverlauf und die komplette Fahrroute gleichermaßen in die Bewertung einfließen.

Abhängig von der Ausgabe 44 des Diskriminators 42, wird in Block 5 eine Zielfunktion optimiert, insbesondere eine Verlustfunktion minimiert. Hierzu sind die Eingangsgrößen des Diskriminators insbesondere als echte Samples (d.h. Paare mit im Fahrbetrieb bestimmten Fahrverläufen) bzw. als generierte Samples (d.h. Paare mit durch den Generator 41 generierten Fahrverläufen) gelabelt. Die Zielfunktion charakterisiert dabei, inwieweit die generierten Fahrverläufe tatsächlich gemessenen Fahrverläufen entsprechen bzw. inwieweit die Verteilung der generierten Fahrverläufe im Parameterraum der Verteilung der gemessenen Fahrverläufe im Parameterraum entspricht. Abhängig von der Anpassung der Zielfunktion werden die Parameter *θ*_{G} des Generators 41 bzw. des dort umgesetzten generativen Modells sowie die Parameter *θ_{D}* des Diskriminators 42 bzw. des dort umgesetzten diskriminativen Modells angepasst. Die Parameter werden dabei insbesondere bezüglich des Gradienten der Zielfunktion angepasst.

Die Zielfunktion ist derart gewählt, dass sie einen Unterschied bzw. eine Distanz zwischen der Verteilung der generierten Fahrverläufe und Fahrrouten und der Verteilung der im Fahrbetrieb ermittelten Fahrverläufe und Fahrtrouten bzw. einen Unterschied bzw. eine Distanz zwischen der Verteilung der Routen-Fahrverlauf-Paare mit generierten Fahrverläufen und der Verteilung der Routen-Fahrverlauf-Paare mit im Fahrbetrieb ermittelten Fahrverläufen charakterisiert bzw. darstellt. Durch die Wahl einer derartigen Zielfunktion kann das maschinelle Lernsystem derart trainiert werden, dass die Verteilung der generierten Daten die volle Varianz der Verteilung der gemessenen Daten widerspiegelt. Ein sogenannter Mode Collapse wird verhindert. Das heißt, es wird eine repräsentative Verteilung der Fahrverläufe und Fahrtrouten bereitgestellt. Die Zielfunktion berücksichtigt dabei insbesondere auch die Varianz der unbeobachtbaren Einflüsse.

Vorzugsweise wird hierzu als Zielfunktion eine Verlustfunktion (loss) gewählt, welche als Wasserstein-Metrik bzw. Wasserstein-Distanz zwischen den Verteilungen implementiert ist.

In dieser Ausgestaltung des computerimplementierten Trainings sollte der Diskriminator vorzugsweise auf Lipschitzbeschränkte Funktionen beschränkt werden. In einer bevorzugten Ausgestaltung wird die Zielfunktion hierzu um Regularisiererterme erweitert, beispielsweise eine Gradientenbestrafung (Gradient penalty) oder eine Zentrierung (i) der Gradienten der echten Samples (das heißt der Paare mit im Fahrbetrieb bestimmten Fahrverläufen) auf 0 oder (ii) der Gradienten von generierten Samples (das heißt der Paare mit generierten Fahrverläufen) auf 0 oder (iii) der Gradienten von Samples, die das Mittel aus echten und generierten Samples darstellen, auf 1. Besonders bevorzugt wird dabei die Option "Gradient von echten Samples auf 0 zentrieren", da diese sich als die schnellste der Optionen herausgestellt hat und zu einer besonders schnellen Konvergenz des Optimierungsproblems führt. Alternativ kann ein weight clipping nach jedem Gradientenschritt erfolgen.

Die vorstehend beschriebenen Verfahren zum computerimplementierten Training des gesamten Lernsystems inklusive Generator 41 und Diskriminator 42 können als ein Min-Max-Trainingsziel beschrieben werden. Dabei maximiert der Diskriminator 42 seine korrekte Klassifikationsrate, während der Generator 41 die korrekte Klassifikationsrate minimiert, indem er möglichst Fahrverläufe und Fahrrouten generiert, welche den Diskriminator 41 fehlleiten.

Zusätzlich zu den beschriebenen Eingangsgrößen des Generators 41 können diesem auch weitere Eingangsgrößen bereitgestellt werden. Beispielsweise können neben den Zufallsvektoren Informationen über Fahrereigenschaften (wie Erfahrung, Alter, Aggressivität bzw. Fahrstil etc.) oder Fahrzeuginformationen (wie Leistung, Motorisierung, Art des Antriebssystems etc.) gespeichert sein. Die generierten Fahrverläufe können somit auch auf diese zusätzlichen Informationen konditioniert werden. In diesem Fall sind vorteilhafterweise für das Training des maschinellen Lernsystems 4 auch entsprechende Informationen jeweils zu den in Datenbank 2 abgelegten Fahrtrouten abgelegt. Dem Diskriminator werden zu den Routeninformationen und Fahrverläufen aus Datenbank 2 (Schritt 23) als Eingangsgrößen diese zusätzlichen Informationen bereitgestellt.

Ein computerimplementiertes maschinelles Lernsystem, welches mit den beschriebenen Trainingsverfahren angelernt wird, ist in der Lage, repräsentative Fahrverläufe und Fahrtrouten zu generieren, bzw. repräsentative Paare aus Fahrverläufen und Fahrtrouten zu generieren. Hierzu können dem Generator des so angelernten maschinellen Lernsystems Zufallsgrößen und gegebenenfalls weitere Informationen, zugeführt werden und dieser generiert zugehörige Fahrverläufe und Fahrtrouten. Derart generierte Fahrverläufe und oder Fahrtrouten können zur Simulation von Emissionen eines Fahrzeugs und damit beispielsweise zur probabilistischen Beurteilung zur Einhaltung von Abgasnormen und zur Emissionsoptimierung eingesetzt werden. Die Emissionsoptimierung kann beispielsweise durch eine Anpassung des Antriebssystems in der Entwicklung, durch eine Optimierung in der Datenapplikation des Antriebssystems, beispielsweise eines Steuergeräts zur Antriebssystemsteuerung, oder durch eine Anpassung von Steuergrößen des Antriebssystems im Fahrzeug zur Emissionsoptimierung erfolgen. In letzterem Fall kann die Generierung der Fahrverläufe und Fahrtrouten insbesondere im Fahrzeug erfolgen.

Die Fahrverläufe und / oder Fahrtrouten können auch für eine Optimierung prädiktiven Fahrens eingesetzt werden, z.B. im Batteriemanagement eines Elektrofahrzeugs oder E-Bikes, dem Antriebsmanagement eines Hybridfahrzeugs, dem Regenerationsmanagement von Abgaskomponenten eines Fahrzeugs mit Verbrennungsmotors. Die Optimierung kann wiederum in der Entwicklung, durch Optimierung einer entsprechenden Steuergeräteapplikation oder durch Anpassung von Steuergrößen der entsprechenden Systeme im Fahrzeug erfolgen.

Auch für die Ermittlung von Lastkollektiven und Belastungsszenarien zur Spezifikation von Bauteilen können derart generierte Fahrverläufe und / oder Fahrrouten einen wertvollen Beitrag leisten, z.B. welche Belastung erfährt ein bestimmtes Bauteil, wie bspw. eine Pumpe über seine Lebenszeit.

## Patentansprüche

1. Computerimplementiertes Verfahren zum Trainieren eines maschinellen Lernsystems (4) zum Generieren von Fahrverläufen und / oder Fahrtrouten, insbesondere von Geschwindigkeitsverläufen, von Verläufen von Fahrpedalstellungen oder von Verläufen einer Getriebeübersetzung, eines Fahrzeugs, **gekennzeichnet durch** die Schritte:
- ein Generator (41) des maschinellen Lernsystems (4) erhält erste Zufallsvektoren als Eingangsgrößen und generiert zu den ersten Zufallsvektoren jeweils erste Fahrtrouten und zugehörige erste Fahrverläufe,
- in einer Datenbank (2) sind Fahrtrouten und jeweils zugehörige, im Fahrbetrieb erfasste Fahrverläufe abgespeichert,
- aus der Datenbank (2) werden zweite Fahrtrouten sowie jeweils zugehörige zweite, im Fahrbetrieb erfasste Fahrverläufe ausgewählt,
- ein Diskriminator (42) des maschinellen Lernsystems (4) erhält als Eingangsgrößen erste Paare aus ersten generierten Fahrtrouten und jeweils zugehörigen ersten, generierten Fahrverläufen und zweite Paare aus zweiten Fahrtrouten und jeweils zugehörigen zweiten, im Fahrbetrieb erfassten Fahrverläufen,
- der Diskriminator (42) berechnet abhängig von den Eingangsgrößen Ausgaben, welche für jedes als Eingangsgrößen erhaltene Paar charakterisieren, ob es sich um ein erstes Paar aus einer ersten generierten Fahrtroute und einem jeweils zugehörigen ersten, generierten Fahrverlauf oder um ein zweites Paar aus einer zweiten Fahrtroute und einem jeweils zugehörigen zweiten, im Fahrbetrieb erfassten Fahrverlauf handelt,
- abhängig von den Ausgaben des Diskriminators (42) wird eine Zielfunktion (5) optimiert, welche eine Distanz zwischen der Verteilung der ersten Paare und der Verteilung der zweiten Paare darstellt.

2. Verfahren nach Anspruch 1, **dadurch gekennzeichnet, dass** abhängig von der Optimierung der Zielfunktion (5) Parameter des maschinellen Lernsystems (4) derart angepasst werden, dass
- der Diskriminator (42) darauf optimiert wird, zwischen den ersten, generierten Fahrverläufen und Fahrrouten und den zweiten, im Fahrbetrieb erfassten Fahrverläufen und Fahrrouten zu unterscheiden,
- der Generator (41) darauf optimiert wird, erste, generierte Fahrverläufe und Fahrrouten in einer ersten Verteilung zu generieren, welche durch den Diskriminator (42) möglichst schwer von zweiten, im Fahrbetrieb erfassten Fahrverläufen und Fahrrouten zu unterscheiden sind, welche in einer zweiten Verteilung vorliegen.

3. Verfahren nach Anspruch 2, **dadurch gekennzeichnet, dass** die Parameter des maschinellen Lernsystems (4) abhängig von einem Gradienten der Zielfunktion (5) angepasst werden.

4. Verfahren nach einem der vorangegangenen Ansprüche, **dadurch gekennzeichnet, dass** als die Zielfunktion (5) eine statistische Distanz zwischen einer ersten Verteilung der ersten Fahrverläufe und Fahrrouten und einer zweiten Verteilung der zweiten Fahrverläufe und Fahrtrouten, implementiert ist.

5. Verfahren nach Anspruch 4, **dadurch gekennzeichnet, dass** die Zielfunktion (5) als eine Jenson-Shannon-Distanz oder als Wasserstein-Metrik, insbesondere als eine Wasserstein-Distanz zwischen einer ersten Verteilung der ersten Fahrverläufe und Fahrtrouten und einer zweiten Verteilung der zweiten Fahrverläufe und Fahrtrouten, implementiert ist.

6. Verfahren nach Anspruch 5, **dadurch gekennzeichnet, dass** die Zielfunktion (5) um einen Reglementierer erweitert wird oder ein weight clipping erfolgt.

7. Verfahren nach einem der vorangegangenen Ansprüche, **dadurch gekennzeichnet, dass** die ersten und die zweiten Fahrtrouten in zeitlichen oder räumlichen Diskretisierungsschritten vorliegende Daten sind, wobei zu jeder Route in jedem Diskretisierungsschritt Routeneigenschaften gespeichert sind.

8. Verfahren nach Anspruch 7, **dadurch gekennzeichnet, dass** die Routeneigenschaften geografische Eigenschaften, Eigenschaften des Verkehrsflusses, Fahrbahneigenschaften, Eigenschaften der Verkehrsführung und / oder Wettereigenschaften der Route umfassen.

9. Verfahren nach einem der vorangegangenen Ansprüche, **dadurch gekennzeichnet, dass** die Eingangsgrößen des Generators (41) und des Diskriminators (42 zusätzliche Informationen umfassen, insbesondere Fahrereigenschaften und / oder Fahrzeugeigenschaften.

10. Verfahren nach einem der vorangegangenen Ansprüche, **dadurch gekennzeichnet, dass** die Zufallsvektoren entweder als globale Zufallsvektoren oder als temporäre oder lokale Zufallsvektoren implementiert werden.

11. Verfahren nach einem der Ansprüche 1 bis 9, **dadurch gekennzeichnet, dass** die Zufallsvektoren als eine Kombination von globalen und von temporären oder lokalen Zufallsvektoren implementiert werden.

12. Verfahren nach einem der vorangegangenen Ansprüche, **dadurch gekennzeichnet, dass** der Generator (41) und / oder der Diskriminator (42) jeweils als neuronales Netz, insbesondere als rekurrentes neuronales Netz implementiert sind.

13. Verfahren nach Anspruch 12, **dadurch gekennzeichnet, dass** der Generator (41) als bidirektionales rekurrentes neuronales Netz implementiert ist.

14. Verfahren nach einem der vorangegangenen Ansprüche, **dadurch gekennzeichnet, dass** die Länge der generierten Fahrverläufe und generierten Fahrrouten abhängig von einer vorbestimmten oder konfigurierbaren Eingangsgröße oder abhängig von einem Abbruchkriterium bestimmt wird.

15. Verfahren zum Generieren von Fahrverläufen und / oder Fahrrouten eines Fahrzeugs, wobei ein computerimplementierter Generator (41) eines maschinellen Lernsystems (4) mit einem Verfahren nach einem der Ansprüche 1 bis 14 angelernt wird und die Fahrverläufe anschließend vom Generator (41) generiert werden.

16. Verfahren zum Bewerten von Fahrverläufen und / oder Fahrrouten eines Fahrzeugs, wobei ein computerimplementierter Diskriminator (42) eines maschinellen Lernsystems (4) mit einem Verfahren nach einem der Ansprüche 1 bis 14 trainiert wird und die Fahrverläufe und / oder Fahrtrouten anschließend vom Diskriminator (42) beurteilt werden.

17. Verfahren zur Ermittlung von routenspezifischen Emissionen eines Antriebssystems eines Fahrzeugs, wobei Fahrverläufe und/oder Fahrrouten mit einem Verfahren nach Anspruch 15 generiert werden und die routenspezifischen Emissionen abhängig von den Fahrverläufen und / oder Fahrrouten ermittelt werden.

18. Verfahren nach Anspruch 17, **dadurch gekennzeichnet, dass** die Emissionen in einer Simulation ermittelt werden, in welcher ein Modell des Antriebssystems berechnet wird.

19. Verfahren nach Anspruch 18, **dadurch gekennzeichnet, dass** das Modell des Antriebssystems Teilmodelle umfasst, welche einen Motor und ein Abgasnachbehandlungssystem des Antriebssystems beschreiben.

20. Verfahren zur Anpassung eines Antriebssystems eines Fahrzeugs, **dadurch gekennzeichnet**, wobei routenspezifische Emissionen mit einem Verfahren nach einem der Ansprüche 17 bis 19 ermittelt werden und das Antriebssystem des Fahrzeugs anschließend abhängig von den routenspezifischen Emissionen angepasst wird.

21. Verfahren nach Anspruch 20, **dadurch gekennzeichnet, dass** die Anpassung durch die Anpassung von Komponenten oder Parametern in der Entwicklung des Antriebssystems, durch eine Anpassung von Daten in einer Applikation des Antriebssystems oder durch eine Anpassung von Steuergrößen im Betrieb des Antriebssystems im Fahrzeug erfolgt.

22. Computerprogramm, welches dazu eingerichtet ist, ein Verfahren nach einem der vorangegangenen Ansprüche durchzuführen.

23. Maschinenlesbares Speichermedium, auf welchem ein Computerprogramm nach Anspruch 22 abgelegt ist.

24. Computerimplementiertes maschinelles Lernsystem (4) mit einem maschinenlesbaren Speichermedium nach Anspruch 23.

## Claims

1. Computer-implemented method for training a machine learning system (4) for generating driving profiles and/or driving routes, in particular speed profiles, profiles of accelerator pedal positions or profiles of a gear ratio, of a vehicle, **characterized by** the steps of:
- a generator (41) of the machine learning system (4) obtaining first random vectors as input variables and generating first driving routes and associated first driving profiles each relating to the first random vectors,
- driving routes and respectively associated driving profiles recorded in driving mode being stored in a database (2),
- second driving routes and also respectively associated second driving profiles recorded in driving mode being selected from the database (2),
- a discriminator (42) of the machine learning system (4) obtaining as input variables first pairs made up of first generated driving routes and respectively associated first, generated driving profiles and second pairs made up of second driving routes and respectively associated second driving profiles recorded in driving mode,
- the discriminator (42) calculating, as a function of the input variables, outputs which characterize for each pair, obtained as input variables, whether the pair is a first pair made up of a first generated driving route and a respectively associated first, generated driving profile or a second pair made up of a second driving route and a respectively associated second driving profile recorded in driving mode,
- a target function (5) being optimized as a function of the outputs of the discriminator (42), the target function representing a distance between the distribution of the first pairs and the distribution of the second pairs.

2. Method according to Claim 1, **characterized in that** parameters of the machine learning system (4) are adapted as a function of the optimization of the target function (5) in such a way that
- the discriminator (42) is optimized for distinguishing between the first, generated driving profiles and driving routes and the second driving profiles and driving routes recorded in driving mode,
- the generator (41) is optimized for generating first, generated driving profiles and driving routes in a first distribution, it being extremely difficult for the discriminator (42) to distinguish the first, generated profiles and driving routes from second driving profiles and driving routes recorded in driving mode which are present in a second distribution.

3. Method according to Claim 2, **characterized in that** the parameters of the machine learning system (4) are adapted as a function of a gradient of the target function (5) .

4. Method according to any of the preceding claims, **characterized in that** a statistical distance between a first distribution of the first driving profiles and driving routes and a second distribution of the second driving profiles and driving routes is implemented as the target function (5).

5. Method according to Claim 4, **characterized in that** the target function (5) is implemented as a Jenson-Shannon distance or as a Wasserstein metric, in particular as a Wasserstein distance between a first distribution of the first driving profiles and driving routes and a second distribution of the second driving profiles and driving routes.

6. Method according to Claim 5, **characterized in that** the target function (5) is expanded by a regulator or weight clipping is performed.

7. Method according to any of the preceding claims, **characterized in that** the first and the second driving routes are data present in temporal or spatial discretization steps, wherein route properties are stored in each discretization step for each route.

8. Method according to Claim 7, **characterized in that** the route properties comprise geographical properties, traffic flow properties, roadway properties, traffic management properties and/or weather properties of the route.

9. Method according to any of the preceding claims, **characterized in that** the input variables of the generator (41) and of the discriminator (42) comprise additional information, in particular driver properties and/or vehicle properties.

10. Method according to any of the preceding claims, **characterized in that** the random vectors are implemented either as global random vectors or as temporary or local random vectors.

11. Method according to any of Claims 1 to 9, **characterized in that** the random vectors are implemented as a combination of global and temporary or local random vectors.

12. Method according to any of the preceding claims, **characterized in that** the generator (41) and/or the discriminator (42) are each implemented as a neural network, in particular as a recurrent neural network.

13. Method according to Claim 12, **characterized in that** the generator (41) is implemented as a bidirectional recurrent neural network.

14. Method according to any of the preceding claims, **characterized in that** the length of the generated driving profiles and generated driving routes is determined as a function of a predetermined or configurable input variable or as a function of a termination criterion.

15. Method for generating driving profiles and/or driving routes of a vehicle, wherein a computer-implemented generator (41) of a machine learning system (4) is taught using a method according to any of Claims 1 to 14 and the driving profiles are then generated by the generator (41).

16. Method for assessing driving profiles and/or driving routes of a vehicle, wherein a computer-implemented discriminator (42) of a machine learning system (4) is trained using a method according to any of Claims 1 to 14 and the driving profiles and/or driving routes are then assessed by the discriminator (42).

17. Method for ascertaining route-specific emissions of a drive system of a vehicle, wherein driving profiles and/or driving routes are generated using a method according to Claim 15 and the route-specific emissions are ascertained as a function of the driving profiles and/or driving routes.

18. Method according to Claim 17, **characterized in that** the emissions are ascertained in a simulation in which a model of the drive system is calculated.

19. Method according to Claim 18, **characterized in that** the model of the drive system comprises partial models which describe an engine and an exhaust gas aftertreatment system of the drive system.

20. Method for adapting a drive system of a vehicle, **characterized in that** route-specific emissions are ascertained using a method according to any of Claims 17 to 19 and the drive system of the vehicle is then adapted as a function of the route-specific emissions.

21. Method according to Claim 20, **characterized in that** the adaptation is made by adapting components or parameters in the development of the drive system, by adapting data in an application of the drive system or by adapting control variables during operation of the drive system in the vehicle.

22. Computer program which is configured to carry out a method according to any of the preceding claims.

23. Machine-readable storage medium on which a computer program according to Claim 22 is stored.

24. Computer-implemented machine learning system (4) having a machine-readable storage medium according to Claim 23.

## Revendications

1. Procédé mis en œuvre par ordinateur pour entraîner un système d'apprentissage automatique (4) à générer des tracés de déplacement et/ou des itinéraires de déplacement, notamment des tracés de vitesse, des tracés de positions de pédale d'accélérateur ou des tracés d'un rapport de transmission, d'un véhicule, **caractérisé par** les étapes :
- un générateur (41) du système d'apprentissage automatique (4) reçoit des premiers vecteurs aléatoires sous la forme de grandeurs d'entrée et génère, pour les premiers vecteurs aléatoires, respectivement des premiers itinéraires de déplacement et des premiers tracés de déplacement associés,
- les itinéraires de déplacement et les tracés de déplacement respectivement associés, acquis en régime de déplacement, sont enregistrés dans une base de données (2),
- deux itinéraires de déplacement ainsi que des deuxièmes tracés de déplacement respectivement associés, acquis en régime de déplacement, sont sélectionnés à partir de la base de données (2),
- un discriminateur (42) du système d'apprentissage automatique (4) reçoit, en tant que grandeurs d'entrée, des premières paires de premiers itinéraires de déplacement générés et de premiers tracés de déplacement respectivement associés générés, et des deuxièmes paires de deuxièmes itinéraires de déplacement et de deuxièmes tracés de déplacement respectivement associés, acquis en régime de déplacement,
- le discriminateur (42) calcule, en fonction des grandeurs d'entrée, des résultats en sortie qui caractérisent, pour chaque paire reçue en tant que grandeur d'entrée, s'il s'agit d'une première paire constituée d'un premier itinéraire de déplacement généré et d'un premier tracé de déplacement respectivement associé généré, ou d'une deuxième paire constituée d'un deuxième itinéraire de déplacement et d'un deuxième tracé de déplacement respectivement associé, acquis en régime de déplacement,
- une fonction cible (5) est optimisée en fonction des résultats en sortie du discriminateur (42), laquelle représente une distance entre la distribution des premières paires et la distribution des deuxièmes paires.

2. Procédé selon la revendication 1, **caractérisé en ce que** des paramètres du système d'apprentissage automatique (4) sont adaptés en fonction de l'optimisation de la fonction cible (5) de telle sorte que
- le discriminateur (42) est optimisé pour faire la distinction entre les premiers tracés de déplacement et itinéraires de déplacement générés et les deuxièmes tracés de déplacement et itinéraires de déplacement acquis en régime de déplacement,
- le générateur (41) est optimisé pour générer les premiers tracés de déplacement et itinéraires de déplacement dans une première distribution, lesquels sont aussi difficiles que possible à distinguer par le discriminateur (42) des deuxièmes tracés de déplacement et itinéraires de déplacement acquis en régime de déplacement, qui sont présents dans une deuxième distribution.

3. Procédé selon la revendication 2, **caractérisé en ce que** les paramètres du système d'apprentissage automatique (4) sont adaptés en fonction d'un gradient de la fonction cible (5).

4. Procédé selon l'une des revendications précédentes, **caractérisé en ce que** la fonction cible (5) mise en œuvre est une distance statistique entre une première distribution des premiers tracés de déplacement et itinéraires de déplacement et une deuxième distribution des deuxièmes tracés de déplacement et itinéraires de déplacement.

5. Procédé selon la revendication 4, **caractérisé en ce que** la fonction cible (5) est mise en œuvre sous la forme d'une distance Jensen-Shannon ou d'un indice de mesure de Wasserstein, notamment sous la forme d'une distance de Wasserstein entre une première distribution des premiers tracés de déplacement et itinéraires de déplacement et une deuxième distribution des deuxièmes tracés de déplacement et itinéraires de déplacement.

6. Procédé selon la revendication 5, **caractérisé en ce que** la fonction cible (5) est étendue par un régulateur ou un écrêtage de poids est effectué.

7. Procédé selon l'une des revendications précédentes, **caractérisé en ce que** les premiers et deuxièmes itinéraires de déplacement sont des données présentes dans des étapes de discrétisation temporelle ou spatiale, des caractéristiques d'itinéraire étant mémorisées pour chaque itinéraire dans chaque étape de discrétisation.

8. Procédé selon la revendication 7, **caractérisé en ce que** les caractéristiques d'itinéraire comprennent des caractéristiques géographiques, des caractéristiques du flux de trafic, des caractéristiques de la chaussée, des caractéristiques de guidage du trafic et/ou des caractéristiques météorologiques de l'itinéraire.

9. Procédé selon l'une des revendications précédentes, **caractérisé en ce que** les grandeurs d'entrée du générateur (41) et du discriminateur (42) comprennent des informations supplémentaires, notamment des caractéristiques de conducteur et/ou des caractéristiques de véhicule.

10. Procédé selon l'une des revendications précédentes, **caractérisé en ce que** les vecteurs aléatoires sont mis en œuvre soit sous la forme de vecteurs aléatoires globaux, soit sous la forme de vecteurs aléatoires temporaires ou locaux.

11. Procédé selon l'une des revendications 1 à 9, **caractérisé en ce que** les vecteurs aléatoires sont mis en œuvre sous la forme d'une combinaison de vecteurs aléatoires globaux et de vecteurs aléatoires temporaires ou locaux.

12. Procédé selon l'une des revendications précédentes, **caractérisé en ce que** le générateur (41) et/ou le discriminateur (42) sont respectivement mis en œuvre sous la forme de réseau neuronal, en particulier sous la forme de réseau neuronal récurrent.

13. Procédé selon la revendication 12, **caractérisé en ce que** le générateur (41) est mis en œuvre sous la forme d'un réseau neuronal récurrent bidirectionnel.

14. Procédé selon l'une des revendications précédentes, **caractérisé en ce que** la longueur des tracés de déplacement générés et des itinéraires de déplacement générés est déterminée en fonction d'une grandeur d'entrée prédéterminée ou configurable ou en fonction d'un critère d'interruption.

15. Procédé de génération de tracés de déplacement et/ou d'itinéraires de déplacement d'un véhicule, un générateur (41) mis en œuvre par ordinateur d'un système d'apprentissage automatique (4) étant formé par un procédé selon l'une des revendications 1 à 14 et les tracés de déplacement étant ensuite générés par le générateur (41).

16. Procédé d'évaluation de tracés de déplacement et/ou d'itinéraires de déplacement d'un véhicule, un générateur (42) mis en œuvre par ordinateur d'un système d'apprentissage automatique (4) étant entraîné par un procédé selon l'une des revendications 1 à 14 et les tracés de déplacement et/ou les itinéraires de déplacement étant ensuite évalués par le discriminateur (42) .

17. Procédé de détermination d'émissions spécifiques à des itinéraires d'un système de propulsion d'un véhicule, des tracés de déplacement et/ou des itinéraires de déplacement étant générés avec un procédé selon la revendication 15 et les émissions spécifiques à des itinéraires étant déterminées en fonction des tracés de déplacement et/ou des itinéraires de déplacement.

18. Procédé selon la revendication 17, **caractérisé en ce que** les émissions sont déterminées dans une simulation dans laquelle un modèle du système de propulsion est calculé.

19. Procédé selon la revendication 18, **caractérisé en ce que** le modèle du système de propulsion comprend des modèles partiels qui décrivent un moteur et un système de post-traitement des gaz d'échappement du système de propulsion.

20. Procédé d'adaptation d'un système de propulsion d'un véhicule, **caractérisé en ce que** des émissions spécifiques aux itinéraires sont déterminées avec un procédé selon l'une des revendications 17 à 19 et le système de propulsion du véhicule est ensuite adapté en fonction des émissions spécifiques aux itinéraires.

21. Procédé selon la revendication 20, **caractérisé en ce que** l'adaptation est réalisée par l'adaptation de composants ou de paramètres dans le développement du système de propulsion, par une adaptation de données dans une application du système de propulsion ou par une adaptation de grandeurs de commande dans le fonctionnement du système de propulsion dans le véhicule.

22. Programme informatique, lequel est conçu pour mettre en œuvre un procédé selon l'une des revendications précédentes.

23. Support de stockage lisible par machine, sur lequel est stocké un programme informatique selon la revendication 22.

24. Système d'apprentissage automatique (4) mis en œuvre par ordinateur, comprenant un support de stockage lisible par machine selon la revendication 23.
